(19) Europäisches Patentamt

European Patent Office

Office européen des brevets

(11) **EP 1 342 321 B1**

(12) **EUROPÄISCHE PATENTSCHRIFT**

(45) Veröffentlichungstag und Bekanntmachung des Hinweises auf die Patenterteilung:
**29.09.2004  Patentblatt 2004/40**

(21) Anmeldenummer: **01989361.9**

(22) Anmeldetag: **03.12.2001**

(51) Int Cl.⁷: $H03L\ 7/081$, $H04L\ 7/033$

(86) Internationale Anmeldenummer:
**PCT/DE2001/004523**

(87) Internationale Veröffentlichungsnummer:
**WO 2002/047270 (13.06.2002 Gazette 2002/24)**

(54) **PHASENREGELSCHLEIFE ZUR RÜCKGEWINNUNG EINES TAKTSIGNALS AUS EINEM DATENTSIGNAL**

PHASE LOCK LOOP FOR RECOVERING A CLOCK SIGNAL FROM A DATA SIGNAL

BOUCLE A PHASE ASSERVIE POUR LA RECUPERATION D'UN SIGNAL D'HORLOGE A PARTIR D'UN SIGNAL DE DONNEES

(84) Benannte Vertragsstaaten:
**DE FR GB**

(30) Priorität: **07.12.2000  DE 10060911**

(43) Veröffentlichungstag der Anmeldung:
**10.09.2003  Patentblatt 2003/37**

(73) Patentinhaber: **Infineon Technologies AG**
**81669 München (DE)**

(72) Erfinder: **UNTERRICKER, Reinhold**
**85591 Vaterstetten (DE)**

(74) Vertreter: **Epping Hermann & Fischer**
**Ridlerstrasse 55**
**80339 München (DE)**

(56) Entgegenhaltungen:
**EP-A- 0 556 984         WO-A-91/16766**
**US-A- 3 820 034         US-A- 5 081 427**

**Beschreibung**

Die vorliegende Erfindung betrifft eine Phasenregelschleife zur Rückgewinnung eines Taktsignals aus einem Datensignal, aufweisend

- eine Verzögerungsregelschleife mit einem Phasendetektor mit einem ersten Eingang, der mit einem Anschluß zur Zuführung eines vom Taktsignal ableitbaren Signals gekoppelt ist und mit einem zweiten Eingang, der mit einem Anschluß zur Zuführung des Datensignals gekoppelt ist, einem Integrator, der an einen Ausgang des Phasendetektors angeschlossen ist und einem Verzögerungsglied, das mit einem Steuereingang an einen Ausgang des Integrators angeschlossen ist und das ausgangsseitig mit einem der beiden Eingänge des Phasendetektors verbunden ist,
- ein Schleifenfilter, welches an den Ausgang des Integrators angeschlossen ist und
- einen spannungsgesteuerten Oszillator, der eingangsseitig an einen Ausgang des Schleifenfilters angeschlossen ist und an dessen Ausgang das Taktsignal ableitbar ist.

Die Rückgewinnung eines Taktsignals aus einem empfangenen Datensignal, beispielsweise einem Binärsignal mit zufälliger Folge von 0 und 1, ist eine zentrale Problemstellung in der Datentechnik und der Telekommunikationstechnik.

Ein möglicher Lösungsweg ist der Einsatz einer Phasenregelschleife mit einem digitalen Phasendetektor, welcher ein Stellsignal für einen lokalen Oszillator erzeugt. Dabei wird in einem derartigen digitalen Phasendetektor jeweils zu den Flankenwechseln im Datensignal, das heißt von der logischen 0 zur logischen 1 und umgekehrt, die Phasenlage dieses Datensignals mit der Taktphase des Taktsignals verglichen. Der Phasendetektor stellt dabei an seinem Ausgang die Information "Takt zu früh", "Takt zu spät" oder "Takt richtig oder Phase unbekannt" bereit. Mit dieser Signalinformation wird eine Frequenz eines Ausgangssignals eines lokalen, spannungsgesteuerten Oszillators (VCO, Voltage Controlled Oscillator) umgetastet und somit die Phasenlage des Datensignals verfolgt. Dieses Prinzip ist beispielsweise in dem Aufsatz "Clock Recovery from Random Binary Signals", J. D. H. Alexander, Electronics Letters Vol. 11, No. 22 (1975), Seiten 541 bis 542 sowie in dem Aufsatz "Si Bipolar Phase and Frequency Detector IC for Clock Extraction up to 8 Gb/s", A. Pottbäkker, U. Langmann, IEEE Journal of Solid-State Circuits, Vol. 27, No. 12 (1992), Seiten 1747 bis 1751 angegeben.

Die Verwendung eines digitalen Phasendetektors in einer PLL, Phase Locked Loop, zur Taktsignalgewinnung aus einem Datensignal ist schaltungstechnisch einfach realisierbar. Die digitale oder nichtlineare Wirkungsweise des Phasendetektors ist für das Übertragungssystem gegenüber einer linearen Wirkungsweise jedoch dahingehend von Nachteil, daß bei einer Phasenabweichung lediglich das Vorzeichen derselben, nicht aber die Größe der Abweichung erkannt wird. Folglich kann keine lineare Übertragungsfunktion des Systems und keine Modulationsbandbreite für die Phasenmodulation angegeben werden. Da jedoch in der Telekommunikationstechnik die Übertragung von Daten über weite Strecken eine häufige Aufgabenstellung ist, bei der viele Signal-Regeneratoren in Reihe zu schalten sind, ist es wünschenswert, daß Schaltungen zur Taktrückgewinnung linear sind und eine wohldefinierte Modulationsbandbreite aufweisen.

Aus dem Dokument DE 198 42 711 A1 ist eine Schaltung zur Datensignalrückgewinnung und Taktsignalregenerierung bekannt, bei der neben der PLL zur Taktrückgewinnung mit digitalem Phasendetektor eine zweite PLL mit einem linearen, analogen Phasendetektor vorgesehen ist, welche der ersten PLL nachgeschaltet ist und ein Ausgangstaktsignal aus dem in der ersten Stufe erzeugten Takt erzeugt. Für eine derartige Schaltung ist jedoch ein zweiter spannungsgesteuerter Oszillator mit dem damit verbundenen zusätzlichen Aufwand erforderlich.

In dem Aufsatz "A 155-MHz Clock Recovery Delay- and Phase-Locked Loop", T. H. Lee, J. F. Bulzacchelli, IEEE Journal of Solid-State Circuits, Vol. SC-27, Dec. 1992, Seiten 1736 bis 1746 ist eine gattungsgemäße Schaltung bekannt, bei der eine Verzögerungsregelschleife, DLL, Delay Locked Loop, mit einer Phasenregelschleife, PLL in einer Parallelschaltung kombiniert ist. Damit ist es möglich, eine sehr schnelle Taktsignalrückgewinnung mit hoher Leistungsfähigkeit und guten Jitter-Eigenschaften zu erreichen. Der verwendete Phasendetektor kann dabei mehrere, beispielsweise fünf Ausgangswerte annehmen, welche in einem Schleifen-Integrator zu einem Dreieckssignal integriert werden.

Die dort beschriebene Regelschleife weist als Schleifenfilter (Loop Filter) einen reinen Integrator ohne Proportionalanteil auf, siehe Figur 9, mit der Funktion $H_f = K_D / s$. An den Ausgang dieses Schleifenfilters ist ein VCO, Voltage Controlled Oscillator, angeschlossen. Dieser VCO muß als hochgenauer Quarzoszillator (VCXO) ausgeführt sein, dessen Frequenz nur unwesentlich von der Datenrate abweicht. Jede Abweichung der Oszillatorfrequenz von der Datenrate des Datensignals muß mittels eines stationären Stellwertes des Schleifenfilters ausgeglichen werden, der auch das steuerbare Verzögerungsglied regelt. Hierdurch ist der Phasen-Regelbereich der Verzögerungsschleife eingeschränkt, wie im Kapitel "C. Acquisition Behavior of the D/PLL" erläutert.

Die Dimensionierung der beschriebenen D/PLL erfolgt mittels den beiden Polen der Phasenübertragungsfunktion(Jitter Transfer Function) H(s), siehe Kapitel B, die mit den DLL-Parametern $K_D$ und $K_\Phi$ sowie dem PLL-Parameter $K_O$ eingestellt werden können. Zur richtigen Dimensionierung dieser linearen Funktion sind jedoch lineare Bauteile, insbesondere ein linearer Phasendetektor mit definierter Detektorkonstante $K_D$, erforderlich. Dieser Phasendetektor muß neben einer qualitativen Aussage auch eine quantitative Aussage zur Phasenabweichung machen können.

Aufgabe der vorliegenden Erfindung ist es, eine Phasenregelschleife zur Rückgewinnung eines Taktsignals aus einem Datensignal gemäß dem Oberbegriff derart weiterzubilden, daß eine lineare Phasenregelschleife mit weiter vereinfachtem Aufbau möglich ist.

Erfindungsgemäß wird die Aufgabe mit einer Phasenregelschleife zur Rückgewinnung eines Taktsignals aus einem Datensignal gemäß dem Oberbegriff gelöst, welche dahingehend weitergebildet ist, daß der Phasendetektor ein nichtlinearer Phasendetektor ist.

Ein Taktsignal weist üblicherweise eine vorher festgelegte, bekannte Reihenfolge von binär codierten Nullen und Einsen auf, die sich normalerweise abwechseln.

Ein Datensignal hingegen trägt codierte Informationen, die beispielsweise einem Empfänger nicht a priori bekannt sind, wie Sprachdaten, Textdaten, Grafikdaten oder andere. Daher muß, selbst wenn mit einem Scrambler eine Gleichwahrscheinlichkeit des Auftretens von Nullen und Einsen gemittelt über einen längeren Zeitraum erzielt ist, beispielsweise am Empfänger nicht bekannt sein, welche Taktinformation dem Datensignal zugrundeliegt. Folglich kommt der Rückgewinnung eines Taktsignals aus einem Datensignal in der Informations- und Kommunikationstechnik eine zentrale Bedeutung zu.

Die Nichtlinearität oder Digitalität des Phasendetektors zeichnet sich insbesondere dadurch aus, daß der Phasendetektor zwar eine qualitative Aussage macht, ob die Phasenabweichung zwischen zwei Eingangssignalen positiv oder negativ ist, nicht jedoch eine quantitative Aussage über die Größe dieser Phasenabweichung. Derartige Phasendetektoren werden auch als "Bang-Bang-Detektor" bezeichnet. Sie zeichnen sich insbesondere dadurch aus, mit verhältnismäßig geringem Aufwand schaltungstechnisch realisierbar zu sein.

Der Phasendetektor kann dabei an seinem Ausgang ein Signal bereitstellen, welches beispielsweise drei Werte annehmen kann, nämlich Takt zu früh, Takt richtig oder Takt zu spät, in Abhängigkeit davon, ob die Phasenlage des Taktsignals der des Datensignals vor- oder nacheilt oder mit ihr übereinstimmt beziehungsweise momentan nicht bekannt ist. Ein derartiges Signal am Ausgang kann ein ternäres Signal sein, welches einen positiven Wert besitzt, wenn der Phasenunterschied ein positives Vorzeichen hat, einen negativen Wert, wenn der Phasenunterschied ein negatives Vorzeichen hat, oder den Wert Null hat, wenn der Phasenunterschied Null ist oder momentan nicht ermittelt werden kann. Das Signal am Ausgang liefert jedoch keine quantitative Aussage über die Größe des Phasenunterschiedes.

Am Ausgang des Phasendetektors kann alternativ ein binäres Signal bereitgestellt sein, welches entweder eine logische Null oder eine logische Eins liefert, abhängig davon, ob der Phasenunterschied positives oder negatives Vorzeichen hat.

Damit sind die Vorteile der mit einer DLL kombinierten PLL, welche eine hohe Performance ermöglicht, mit den Vorteilen des einfachen Aufbaus und der einfachen Implementierung eines digitalen Phasendetektors kombiniert. Die Verzögerungs-Regelschleife DLL mit dem digitalen Phasendetektor sowie dem Integrator und dem Verzögerungsglied, welches steuerbar ausgeführt sein kann, stellt dabei insgesamt eine Teilschaltung dar, welche bezüglich ihrer elektrischen Eigenschaften einem linearen, analogen Phasendetektor entspricht.

Gemäß dem vorliegenden Prinzip wird mit einem nichtlinearen Phasendetektor ein in die Schaltung eintreffendes Datensignal mit einem Taktsignal verglichen. Dabei wird entweder das Datensignal oder das Taktsignal dem Phasendetektor verzögert zugeführt. Der Phasendetektor kann an seinem Ausgang ein Stellsignal, beispielsweise eine ternäre Stellspannung, bereitstellen, mit dem ein dem digitalen Phasendetektor nachgeschalteter Integrator angesteuert wird. Der Ausgang des Integrators ist zur Bildung einer DLL mit einem Verzögerungsglied verbunden, welches sich entweder im Daten- oder im Taktsignalpfad eingangsseitig am digitalen Phasendetektor befindet. Das Verzögerungsglied kann dabei als gesteuertes Verzögerungsglied ausgeführt sein. Dabei wird die Verzögerung mit dem am Ausgang des Integrators bereitgestellten Signal gesteuert.

Dieser Regelkreis bildet eine Verzögerungsregelschleife, DLL. Dabei wird entweder die Taktphase der Datenphase oder die Datenphase der momentanen Taktphase in einem nichtlinearen, sehr schnell ausgelegten Regelvorgang nachgeführt. Das am Ausgang des Integrators bereitgestellte Ausgangssignal der DLL hängt linear von Abweichungen der Taktphase von der Datensignalphase ab, wenn das an einem Eingang des digitalen Phasendetektors angeschlossene Verzögerungsglied eine lineare Kennlinie aufweist.

In der Phasenregelschleife wird das am Ausgang des Integrators bereitgestellte Signal nunmehr in einem dem Integrator nachgeschalteten Schleifenfilter gefiltert und steuert einen dem Schleifenfilter nachgeschalteten spannungsgesteuerten Oszillator an. Das Schleifenfilter kann dabei einen Proportionalanteil aufweisen, mit dem die Bandbreite der PLL dimensionierbar ist und einen Integralanteil, mit dem die bleibende Regelabweichung zwischen Datensignalphase und Taktsignalphasez zu null oder möglichst gering gemacht werden kann.

In einer bevorzugten Ausführungsform der vorliegenden Erfindung weist das Schleifenfilter, welches dem Integrator nachgeschaltet ist, einen proportionalen Regleranteil auf. Dieser Proportionalanteil dient der eigentlichen Phasenregelung. Bei der vorgeschlagenen Anordnung wird jedoch zur Erzeugung einer Phasenübertragungsfunktion 2. Ordnung nicht die Verzögerungsschleife benutzt, sondern das Schleifenfilter weist einen Integralanteil auf, der den zweiten Pol der Übertragungsfuntion einführt. Dabei ist die Integrationskonstante des Integrierers vernachlässigbar klein. Da hierbei Zeitvorgänge der Verzögerungsregelschleife stets vernachlässigbar klein sind, braucht der Phasendetektor kein lineares Verhalten zu haben. Demnach kann ein einfacherer nichtlinearer Phasendetektor eingesetzt sein.

Die beiden Pole der Phasenübertragungsfunktion können bei vorliegender Anordnung mit den Parametern der Phasenregelschleife dimensioniert werden, ohne daß hierfür ein definierter beziehungsweise linearer Ausgangswert des Phasendetektors erforderlich ist.

Die Phasernübertragungsfunktion einer bevorzugten Ausführungsform der Erfindung ergibt sich zu:

$$H(s) = 1 \frac{1}{1 + s \cdot \frac{K_\tau}{K_o \cdot F} + s^2 \cdot \frac{T}{K_o \cdot K_d \cdot F}}$$

mit F gleich Übertragungsfunktion des Schleifenfilters, $K_\tau$ gleich Konversionssteilheit des Verzögerungsgliedes (Phase / Spannung), $K_o$ gleich Konversionssteilheit des spannungsgesteuerten Oszillators (Kreisfrequenz / Spannung), $K_d$ gleich Phasendetektorkonstante (Spannung / Phase), s gleich komplexe Kreisfrequenz und T gleich Integrationszeitkonstante des Integrators.

Bei Annahme einer vernachlässigbar kleinen Integrationszeitkonstante T ergibt sich die Phasenübertragungsfunktion H(s) zu

$$H(s) = \frac{1}{1 + s \cdot \frac{K_\tau}{K_0 \cdot F}}$$

Darin kommt die Detektorkonstante $K_d$, im Gegensatz zur Phasenübertragungsfunktion $H_{klassisch}(s)$ einer herkömmlichen PLL

$$H_{klassisch}(S) = \frac{1}{1 + s \cdot \frac{K_\tau}{K_o \cdot K_d \cdot F}}$$

nicht vor.

Wie in der klassischen PLL-Theorie wird H(s) bei vorliegender Anordnung von zweiter Ordnung sein, wenn die Übertragungsfunktion F eine gebrochen rationale Funktion erster Ordnung ist, das heißt einen Integralanteil besitzt. Bei der vorgeschlagenen Anordnung kann man zur Dimensionierung das bei einem nichtlinearen oder Bang-Bang Phasendetektor undefinierte

$K_D$ ersetzen durch den Ausdruck $1/K_\tau$ und die Regelschleife zweiter Ordnung als lineares System dimensionieren, obwohl der Phasendetektor nichtlinear ist.

Ein weiterer Vorteil eines Schleifenfilters mit Integralanteil ist, daß eine Abweichung der VCO-Frequenz von der Datenrate des Datensignals durch diesen Integralanteil ausgeregelt wird. Nach Abschluß dieses Regelvorgangs kann die Verzögerungsregelschleife mit demselben Aussteuerbereich betrieben werden, der ohne Frequenzabweichung möglich ist. Demnach ist kein hochgenauer Quarzoszillator erforderlich. Vielmehr kann auch ein in einem großen Bereich abstimmbarer VCO, Voltage Controlled Oscillator, verwendet werden. Dies ist besonders bei hohen Datenraten im Gigahertz-Bereich von Bedeutung, da für derart hohe Frequenzen keine Quarzoszillatoren realisiert werden können.

In einer weiteren, bevorzugten Ausführungsform der vorliegenden Erfindung ist das Verzögerungsglied zwischen dem Anschluß zur Zuführung des Datensignals und dem zweiten Eingang des Phasendetektors angeschlossen. Die Anordnung des Verzögerungsglieds im Datenpfad ist eine mögliche Realisierung des vorgestellten Prinzips. Dadurch ist ein besonders einfacher Schaltungsaufbau möglich.

In einer bevorzugten Ausführungsform, bei der das Verzögerungsglied im Datenpfad angeordnet ist, ist dieses zu seiner Steuerung mit einem Dateneingang an den Ausgang des Integrators angeschlossen.

In einer alternativen Ausführungsform der vorliegenden Erfindung ist das Verzögerungsglied zwischen dem Ausgang des spannungsgesteuerten Oszillators und dem ersten Eingang des Phasendetektors angeschlossen. Das Verzögerungsglied ist hierbei im Taktpfad der Schaltung angeordnet.

In einer weiteren, bevorzugten Ausführungsform der Erfindung ist das Verzögerungsglied bei Anordnung im Taktpfad zu seiner Steuerung an den Ausgang des Integrators angeschlossen.

In einer weiteren, bevorzugten Ausführungsform bei Anordnung des Verzögerungsglieds im Taktpfad ist ein weiteres Verzögerungsglied an dem Ausgang angeschlossen zur Bereitstellung eines Taktausgangssignals. Dabei ist es vorteilhaft, wenn die Verzögerungszeit des weiteren Verzögerungsgliedes kleiner als eine untere Grenze eines Einstellbereiches der Verzögerungszeit des Verzögerungsgliedes im Taktpfad ist.

In einer weiteren, bevorzugten Ausführungsform bei Anordnung des Verzögerungsgliedes im Taktpfad ist an Phasendetektor und Integrator eine Anpaß-Kaskadenschaltung mit zumindest einem Anpaß-Verzögerungsglied vorgesehen, zur Anpassung der Datensignalphase an die Phasenlage des am Oszillator ableitbaren Signals. Hierdurch kann der Toleranzbereich bezüglich Jitter bis an die von der schnellen Verzögerungsregelschleife gesetzten Grenzen ausgedehnt werden.

In einer weiteren, bevorzugten Ausführungsform der vorliegenden Erfindung ist der Integrator als Tiefpaßfilter ausgebildet.

Weitere Einzelheiten der vorliegenden Erfindung sind Gegenstand der Unteransprüche.

Die Erfindung wird nachfolgend an mehreren Ausführungsbeispielen anhand der Zeichnungen näher erläutert. Es zeigen:

Figur 1     ein Blockschaltbild eines ersten Ausführungsbeispiels der Erfindung mit steuerbarem Verzögerungsglied im Datenpfad,

Figur 2     ein Blockschaltbild eines zweiten Ausführungsbeispiels der vorliegenden Erfindung mit steuerbarem Verzögerungsglied im Taktpfad,

Figur 3     die Signalverläufe der Taktsignale aus Figur 2 und

Figur 4     eine Weiterbildung der Phasenregelschleife von Figur 2 mit einer Anpaß-Kaskadenschaltung.

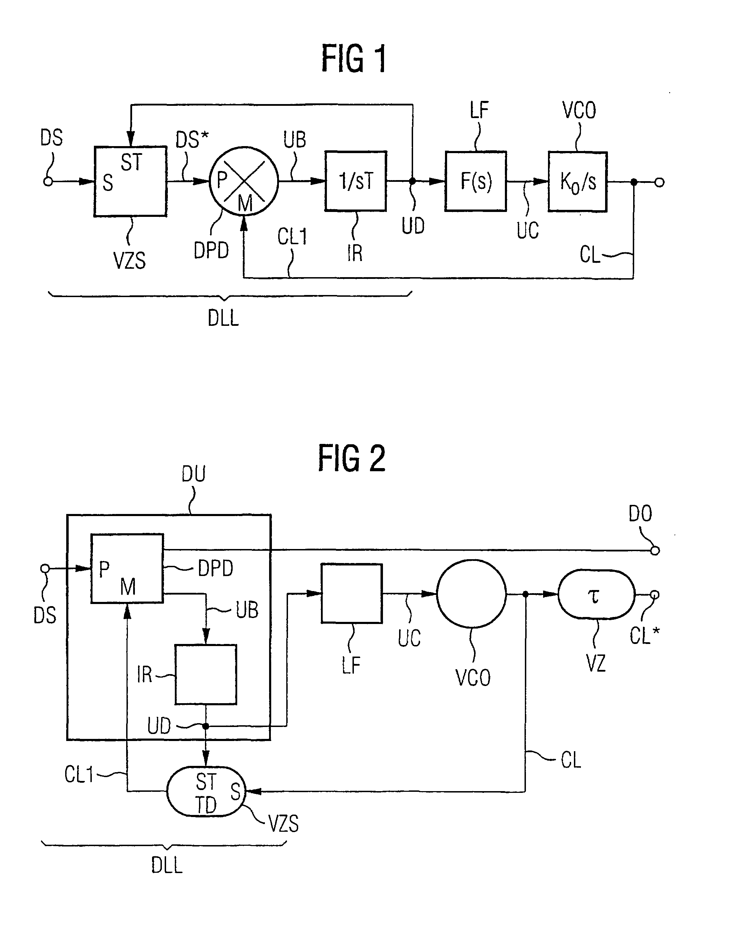

Figur 1 zeigt eine Phasenregelschleife zur Rückgewinnung eines Taktsignals CL aus einem Datensignal DS. Über ein spannungsgesteuertes Verzögerungsglied VZS mit Signaleingang S und Steuereingang S wird das Datensignal DS in ein verzögertes Datensignal DS*gewandelt und einem digitalen Phasendetektor DPD an dessen Plus-Eingang P zugeführt. Das Taktsignal CL wird an einem weiteren, mit M bezeichneten Minus-Eingang des digitalen Phasendetektors zugeführt. An einem Ausgang des digitalen Phasendetektors DPD ist eine Stellspannung UB ableitbar, welche in Abhängigkeit der Phasenlagen der Eingangssignale zueinander einen Spannungswert bereitstellt. Die Stellspannung UB ist dabei eine ternäre Spannung, welche beispielsweise dann einen positiven Spannungswert annimmt, wenn die Phasenlage des Datensignals DS* bezogen auf die Phasenlage des Taktsignals CL zu früh ist, einen negativen Wert, wenn sie zu spät ist, und null, wenn die Phasenlagen miteinander übereinstimmen oder keine Information aus dem Datensignal gewonnen werden kann, weil kein Flankenwechsel im Datensignal DS erfolgt. Am Ausgang des digitalen beziehungsweise nichtlinearen Phasendetektors DPD ist ein Integrator IR angeschlossen, welcher eine Zeitkonstante T aufweist. Diese ist dabei so eingestellt, daß am Ausgang des Integrators IR eine mittlere Spannung UD bereitgestellt ist, welche jeweils über einige Datenbits des Datensignals DS geglättet ist. Die mittlere Spannung UD ist zur Steuerung des spannungsgesteuerten Verzögerungsgliedes VZS durch Zuführen derselben auf den Steuereingang ST des Verzögerungsgliedes VZS bewirkt. Mit der oben angegebenen beispielhaften Definition der Stellspannung UB wirkt die mittlere Spannung UD so auf das Verzögerungsglied VZS, daß dessen Verzögerungszeit mit zunehmender Spannung der mittleren Spannung UD zunimmt. Hierdurch wird eine vorauseilende Phase des Datensignals DS zunehmend verzögert, so daß dieses Voreilen ausgeglichen ist. Die Verschaltung von digitalem Phasendetektor, Integrator und steuerbarem Verzögerungsglied VZS bilden eine Verzögerungsregelschleife DLL. Dabei wird die Phasenlage des verzögerten Datensignals DS* in einem nichtlinear und hier sehr schnell ausgelegten Regelvorgang der Phase des Taktsignals CL nachgeführt. Die am Ausgang des Integrators IR bereitgestellte mittlere Spannung UD hängt dabei von der Abweichung der Phase des Datensignals DS von der Phasenlage des Taktsignals CL ab. Wenn dabei die Kennlinie des spannungsgesteuerten Verzögerungsgliedes VZS linear ist, so werden Schwankungen der Phasenlage des Datensignals DS gegenüber der Phasenlage des Taktsignals CL linear auf die mittlere Spannung UD übertragen.

An den Ausgang des Integrators IR ist weiterhin ein Schleifenfilter LF und an dessen Ausgang ein spannungsgesteuerter Oszillator VCO angeschlossen, so daß in einer Phasenregelschleife mit der mittleren Spannung UD die Frequenz eines am Ausgang des spannungsgesteuerten Oszillators VCO ableitbaren Signals geregelt ist. Das Ausgangssignal des spannungsgesteuerten Oszillators VCO ist dabei gerade das Taktsignal CL, welches dem digitalen Phasendetektor DPD an seinem ersten Eingang zugeführt ist. Das Schleifenfilter LF weist eine Übertragungsfunktion F(s) auf, welche einen Proportionalanteil und einen Integralanteil hat. Dabei ist mit dem proportionalen Regleranteil die Bandbreite der Phasenregelschleife einstellbar. Proportional- und Integralanteil sind weiterhin so dimensionierbar, daß die bleibende Regelabweichung der Phasenlage des Taktsignals CL von der Phasenlage des Datensignals DS* null beträgt.

Die Einschwingzeit der Verzögerungsregelschleife DLL ist so einzustellen, daß diese klein gegenüber der Einschwingzeit der übergeordneten Phasenregelschleife ist. Die Integrationszeitkonstante T des Integrators IR ist entsprechend klein zu wählen. Andererseits sollte die Integrationszeitkonstante T so groß gewählt sein, daß die mittlere Spannung UD über einige Periodendauern des Datensignals hinweg geglättet wird, ohne dabei die Regelvorgänge der übergeordneten Phasenregelschleife zu bestimmen.

Im vorliegenden Ausführungsbeispiel ist folglich ein nichtlinearer, digitaler Phasendetektor DPD in einer Verzögerungsregelschleife DLL angeordnet, wobei am Ausgang des Integrators IR der Verzögerungsregelschleife DLL ein lineares, analoges Signal als Maß für die momentane Regelabweichung der Phasenlagen von Takt- und Datensignal CL, DS bereitsteht. Ein derartiger digitalen Phasendetektor DPD ist besonders einfach realisierbar. Das Schleifenfilter LF ist dabei ein Filter, welches einen Proportionalanteil und einen Integralanteil aufweist, so daß die Taktphase der Phasenlage des Datensignals ohne bleibenden Regelabweichung nachgeregelt werden kann.

Figur 2 zeigt ein Blockschaltbild einer alternativen Ausführungsform der Phasenregelschleife zur Rückgewinnung eines Taktsignals CL aus einem Datensignal DS. Dabei ist das spannungsgesteuerte Verzögerungsglied VZS in Abweichung von der Phasenregelschleife gemäß Figur 1 nicht im Datenpfad, sondern im Taktpfad angeordnet. Demnach wird das Datensignal DS unmittelbar dem digitalen Phasendetektor DPD an einem seiner Eingänge, nämlich dem Plus-Eingang P zugeführt, und das spannungsgesteuerte Verzögerungsglied VZS verzögert das dem digitalen Phasendetektor DPD zuführbare Taktsignal CL um eine Zeitverzögerung TD, so daß ein verzögertes Taktsignal CL1 dem digitalen Phasendetektor DPD zugeführt wird. Wie im ersten Ausführungsbeispiel wird mittels der mittleren Spannung UD die Zeitverzögerung TD des spannungsgesteuerten Verzögerungsgliedes VZS an dessen Steuereingang ST gesteuert. Weiterhin wird mit der mittleren Spannung UD über ein Schleifenfilter LF ein spannungsgesteuerter Oszillator VCO angesteuert, an dessen Ausgang das Taktsignal CL bereitsteht. Mit einem am Ausgang des spannungsgesteuerten Oszillators VCO angeschlossenen weiteren Verzögerungsglied VZ mit einer Zeitverzögerung $\tau$ wird ein Taktausgangssignal CL\* bereitgestellt, welches mit einem am digitalen Phasendetektor DPD ableitbaren Datenausgangssignal D0 korrespondiert. Digitaler Phasendetektor DPD und Integrator IR sind zu einer Detektoreinheit DU zusammengefaßt.

Wie in Figur 1 ist die Stellspannung eine ternäre Spannung, deren Spannungswert die Information Takt zu früh, Takt richtig oder Takt zu spät trägt. Die mittlere Spannung UB hängt dabei von der Phasenlage des Datensignals DS relativ zur Phasenlage des verzögerten Taktsignals CL1 ab. Die mittlere Spannung UD entspricht einer geglätteten Stellspannung UB, welche über einige Datenbits des Datensignals DS hinweg konstant bzw. näherungsweise konstant ist. Mittels der mittleren Spannung UD wird die Zeitverzögerung TD des spannungsgesteuerten Verzögerungsgliedes VZS eingestellt. Die Verzögerungsschleife DLL gemäß Figur 2, welche den digitalen Phasendetektor DPD, den Integrator IR sowie das spannungsgesteuerte Verzögerungsglied VZS umfaßt, führt die Phase des verzögerten Taktsignals CL1 nichtlinear, aber sehr schnell der Phasenlage des Datensignals DS nach. Langsame Schwankungen der Datenphase hingegen werden, bei linearer Kennlinie des spannungsgesteuerten Verzögerungsgliedes VZS, linear auf die mittlere Spannung UD übertragen. Dabei werden die nichtlinearen Eigenschaften des Phasendetektors DPD eliminiert, da die mit dem digitalen Phasendetektor zu erkennende Phasendifferenz im Verzögerungsregelkreis DLL sehr schnell auf null geregelt wird.

Das mittels der Verzögerungsregelschleife DLL am Ausgang des Integrators IR bereitstellbare mittlere Spannungssignal UD, welches zu Phasenschwankungen des Datensignals DS gegenüber dem Taktsignal CL1 proportional ist, steuert über ein Schleifenfilter LF einen spannungsgesteuerten Oszillator VCO an.

Gegenüber der Phasenregelschleife von Figur 1 hat die Phasenregelschleife aus Figur 2 den Vorteil, daß ein in den Taktpfad eingefügtes spannungsgesteuertes Verzögerungsglied VZS einfacher schaltungstechnisch zu realisieren ist als ein im Datenpfad angeordnetes.

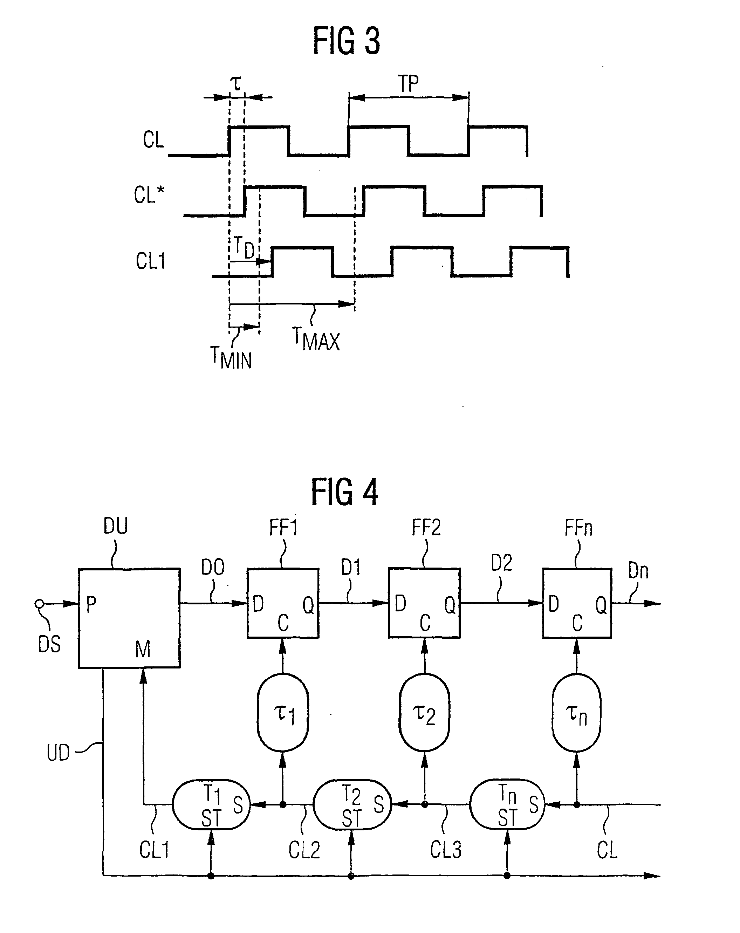

Figur 3 zeigt die Taktsignal-Verläufe der Taktsignale aus Figur 2. Dabei ist das am Ausgang des spannungsgesteuerten Oszillators VCO ableitbare Taktsignal CL, das Taktausgangssignal CL\* sowie das mit dem spannungsgesteuerten Verzögerungsglied VZS um die Zeitverzögerung TD verzögerte Taktsignal CL1 eingezeichnet. Die Zeitverzögerung des Taktausgangssignals CL\* gegenüber dem Taktsignal CL ist mit $\tau$ bezeichnet. Die Zeitverzögerung TD ist in einem Intervall mit den Intervallgrenzen $T_{MIN}$ bis $T_{MAX}$ begrenzten Bereich einstellbar. Für die Intervallgrenzen $T_{MIN}$, $T_{MAX}$ gelten dabei folgende Bedingungen: die minimale Verzögerungszeit $T_{MIN}$ muß größer als die Zeitverzögerung $\tau$ des weiteren Verzögerungsgliedes VZ sein.

$T_{MAX}$ muß kleiner als die Summe aus Zeitverzögerung $\tau$ und Periodendauer des Oszillatorsignals TP sein. Falls für die Schaltungsrealisierung Flip-Flops verwendet werden, welche signifikante Setz- und Haltezeiten haben, so sind diese bei der Aufstellung der Bedingungen für die Intervallgrenzen der Verzögerungszeit TD zu berücksichtigen.

Figur 4 zeigt eine Anpaß-Kaskadenschaltung, welche an die Detektoreinheit DU aus Figur 2 anschließbar ist. Die Anpaß-Kaskade weist dabei mehrere Verzögerungsglieder T1 bis Tn und $\tau_1$ bis $\tau_n$ auf, mit denen die Phasenlage des Datensignals DS sukzessive an die Phasenlage des Taktsignals CL am Ausgang des Oszillators VCO anpaßbar ist. Dabei sind zum einen Verzögerungsglieder mit fester Verzögerungszeit $\tau_1$ bis $\tau n$ und andererseits Verzögerungsglieder mit einstellbarer Verzögerungszeit T1 bis Tn vorgesehen. Die Bezugszeichen $\tau_k$, (k=1..n) sowie $T_k$, (k=1..n) bezeichnen dabei neben den entsprechenden Bauteilen zugleich die Verzögerungszeit des jeweiligen Bauteils.

Für eine fehlerfrei arbeitende Anpaß-Kaskadenschaltung muß die Bedingung $\tau_{k-1} + T_k \geq \tau_k$ erfüllt sein, so daß das k-te Flipflop vor oder gemeinsam mit dem (k-1)-ten Flipflop getriggert wird, wie es bei gewöhnlichen Schieberegistern der Fall ist. Für die minimale Verzögerungszeit eines Verzögerungsgliedes gilt folglich $T_{kmin} >= \tau_k - \tau_{k-1}$ Die maximale Verzögerungszeit eines Verzögerungsgliedes beträgt $T_{MAX} = TP + \tau_k - \tau_{k-1}$. Bei voller Ausnützung des Datenintervalles folgt $T_{MAX} = TP + T_{MIN}$. Daraus folgt, daß die Verzögerungszeit eines Verzögerungsgliedes $T_k$ maximal eine Periodendauer TP überstreichen darf, zum Beispiel von $T_{kmin}$ bis $T_{kmin} + TP$. Die Toleranz der Phasenregelschleife bezüglich Jitter wird demnach bei n Kaskadestufen auf n mal $2\pi$ vergrößert. Dabei wurden jedoch Setz- und Haltezeiten der Flipflops FF1 bis FFn, welche an die Verzögerungsglieder τ1 bis τn angeschlossen sind, unberücksichtigt gelassen. Die Verzögerungsglieder mit einstellbarer Verzögerungszeit $T_1$ bis $T_n$ von Figur 4 ersetzen das steuerbare Verzögerungsglied VZS aus Figur 2. Die mittlere Spannung UD steuert die Verzögerungszeiten aller steuerbarer Verzögerungsglieder $T_1$ bis $T_n$ von Figur 4. Der Ausgang des Oszillators VCO aus Figur 2 ist an den Eingang sowohl des gesteuerten Verzögerungsgliedes $T_n$ als auch des ungesteuerten Verzögerungsgliedes $τ_n$ angeschlossen. Der Ausgang des gesteuerten Verzögerungsgliedes $T_1$, an dem das verzögerte Taktsignal CL1 bereitsteht, ist an den digitalen Phasendetektor DPD in der Detektoreinheit DU angeschlossen. Die gesteuerten Verzögerungsglieder $T_1$ bis $T_n$ sind in Serie geschaltet. An den Ausgang jedes ungesteuerten Verzögerungsgliedes $τ_k$ ist der Takteingang C eines Flipflops FFk, (k=1...n) angeschlossen. Die Flipflops FFk sind hintereinander geschaltet, wobei der Dateneingang D des ersten Flipflops FF1 an den Datenausgang DO der Detektoreinheit DU angeschlossen ist und am Datenausgang Q des n-ten Flipflops FFn ist ein Datenausgangssignal $D_n$ bereitstellbar.

Mit der Anpaß-Kaskadenschaltung gemäß Figur 4 können die Datenausgangssignale am Ausgang des digitalen Phasendetektors DPD in Abhängigkeit von der Geschwindigkeit der Verzögerungsregelschleife DLL auch großen Phasenmodulationen des Eingangs-Datensignals DS mit Frequenzen oberhalb der dimensionierten PLL-Bandbreite folgen.

Bezugszeichenliste

| | |
|---|---|
| C | Takteingang |
| CL | Taktsignal |
| CL1 | vom Taktsignal abgeleitetes Signal |
| CL* | Taktausgangssignal |
| D | Dateneingang |
| D0 | Datenausgangssignal |
| DPD | Digitaler Phasendetektor |
| DS | Datensignal |
| DS* | Verzögertes Datensignal |
| DU | Detektoreinheit |
| FF1 | Flipflop |
| FF2 | Flipflop |
| FFn | Flipflop |
| F(s) | Übertragungsfunktion |
| IR | Integrator |
| LF | Schleifenfilter |
| M | Minus-Eingang |
| P | Plus-Eingang |
| Q | Ausgang |
| S | Signaleingang |
| ST | Steuereingang |
| T | Integrationszeitkonstante |
| TD | Verzögerungszeit |
| τ | Verzögerungszeit |
| $T_{MAX}$ | Maximale Verzögerungszeit |
| $T_{MIN}$ | Minimale Verzögerungszeit |
| TP | Periodendauer |
| τ1 | Verzögerungsglied |
| τ2 | Verzögerungsglied |
| τn | Verzögerungsglied |
| $T_1$ | Verzögerungsglied |
| $T_2$ | Verzögerungsglied |
| $T_n$ | Verzögerungsglied |
| UB | Stellspannung |
| UC | Steuerspannung |
| UD | Mittlere Spannung |
| VCO | spannungsgesteuerter Oszillator |
| VZ | Verzögerungsglied |
| VZS | Spannungsgesteuertes Verzögerungsglied |

**Patentansprüche**

1. Phasenregelschleife zur Rückgewinnung eines Taktsignals (CL) aus einem Datensignal (DS), aufweisend

   - eine Verzögerungsregelschleife (DLL) mit einem Phasendetektor (DPD) mit einem ersten Eingang (M), der mit einem Anschluß zur Zuführung eines vom Taktsignal (CL) ableitbaren Signals (CL1) gekoppelt ist und mit einem zweiten Eingang (P), der mit einem Anschluß zur Zuführung des Datensignals (DS) gekoppelt ist, einem Integrator (IR), der an einen Ausgang des Phasendetektors (DPD) angeschlossen ist und einem Verzögerungsglied (VZS), das mit einem Steuereingang (ST) an einen Ausgang des Integrators (IR) angeschlossen ist und das ausgangsseitig mit einem der beiden Eingänge des Phasendetektors (DPD) verbunden ist,
   - ein Schleifenfilter (LF), welches an den Ausgang des Integrators (IR) angeschlossen ist und
   - einen spannungsgesteuerten Oszillator (VCO), der eingangsseitig an einen Ausgang des Schleifenfilters (LF) angeschlossen ist und an dessen Ausgang das Taktsignal (CL) ableitbar ist,

   **dadurch gekennzeichnet, daß**

   - das Schleifenfilter (LF) einen proportionalen und einen integralen Regleranteil aufweist, und
   - daß der Phasendetektor (DPD) ein nichtlinearer Phasendetektor ist, der an seinem Ausgang ein Signal bereitstellt, welches jeweils einen von lediglich drei Zuständen annehmen kann, umfassend einen ersten Zustand, bei dem die Phase des Taktsignals der Phase des Datensignals voreilt, einen zweiten Zustand, bei dem die Phase des Taktsignals der Phase des Datensignals nacheilt, und einen dritten Zustand, bei dem die Phasenlagen übereinstimmen oder momentan nicht bekannt sind, oder daß der Phasendetektor (DPD) ein nichtlinearer Phasendetektor ist, der an seinem Ausgang ein binäres Signal bereitstellt.

2. Phasenregelschleife nach Anspruch 1, **dadurch gekennzeichnet, daß** das Verzögerungsglied (VZS) zwischen dem Anschluß zur Zuführung des Datensignals (DS) und dem zweiten Eingang des Phasendetektors (DPD) angeschlossen ist.

3. Phasenregelschleife nach Anspruch 2, **dadurch gekennzeichnet, daß** das Verzögerungsglied (VZS) zu dessen Steuerung an den Ausgang des Integrators (IR) angeschlossen ist.

4. Phasenregelschleife nach Anspruch 1, **dadurch gekennzeichnet, daß** das Verzögerungsglied (VZS) zwischen dem Ausgang des spannungsgesteuerten Oszillators (VCO) und dem ersten Eingang des Phasendetektors (DPD) angeschlossen ist.

5. Phasenregelschleife nach Anspruch 4, **dadurch gekennzeichnet, daß** das verzögerungsglied (VZS) zu seiner Steuerung an dem Ausgang des Integrators (IR) angeschlossen ist.

6. Phasenregelschleife nach Anspruch 5, **dadurch gekennzeichnet, daß** ein weiteres Verzögerungsglied (VZ) an den Ausgang des Oszillators (VCO) angeschlossen ist zur Bereitstellung eines Taktausgangssignals (CL*).

7. Phasenregelschleife nach einem der Ansprüche 4 bis 6, **dadurch gekennzeichnet, daß** eine Anpaß-Kaskadenschaltung vorgesehen ist, welche an den digitalen Phasendetektor (DPD) und an den Integrator (IR) angeschlossen ist und zumindest ein weiteres gesteuertes Verzögerungsglied ($T_2$) umfaßt zur Anpassung der Phasenlage eines Datenausgangssignals (D0).

8. Phasenregelschleife nach einem der Ansprüche 1 bis 7, **dadurch gekennzeichnet, daß** der Integrator (IR) als Tiefpaßfilter ausgeführt ist.

9. Phasenregelschleife nach Anspruch 6, **dadurch gekennzeichnet, daß** die Verzögerungszeit (τ) des weiteren Verzögerungsgliedes (VZ) kleiner als eine untere Grenze der einstellbaren Zeitverzögerung (TD) des gesteuerten Verzögerungsgliedes (VZS) ist.

**Claims**

1. Phase locked loop for recovering a clock signal (CL) from a data signal (DS), having

   - a delay locked loop (DLL) having a phase detector (DPD) with a first input (M) which is coupled to a connection for supplying a signal (CL1) which can be derived from the clock signal (CL), and with a second input (P) which is coupled to a connection for supplying the data signal (DS), with an integrator (IR) which is connected to one output of the phase detector (DPD), and with a delay element (VZS) which is connected by means of a control input (ST) to one output of the integrator (IR) and which is connected on the output side to one of the two inputs of the phase detector (DPD),
   - a loop filter (LF) which is connected to the output of the integrator (IR), and
   - a voltage controlled oscillator (VCO) which is connected on the input side to one output of the loop filter (LF) and at whose output the clock signal (CL) can be tapped off,

   **characterized in that**

   - the loop filter (LF) has a proportional regulator component and in an integral regulator component, and
   - **in that** the phase detector (DPD) is a nonlinear phase detector which produces a signal at its output, which can in each case assume one of only three states, comprising a first state in which the phase of the clock signal leads the phase of the data signal, a second state in which the phase of the clock signal lags the phase of the data signal, and a third state in which the phase angles match or are instantaneously unknown, or **in that** the phase detector (DPD) is a nonlinear phase detector, which produces a binary signal at its output.

2. Phase locked loop according to Claim 1, **characterized in that** the delay element (VZS) is connected between the connection supplying the data signal (DS), and the second input of the phase detector (DPD).

3. Phase locked loop according to Claim 2, **characterized in that**, in order to control it, the delay element (VZS) is connected to the output of the integrator (IR).

**4.** Phase locked loop according to Claim 1, **characterized in that** the delay element (VZS) is connected between the output of the voltage controlled oscillator (VCO) and the first input of the phase detector (DPD).

**5.** Phase locked loop according to Claim 4, **characterized in that**, in order to control it, the delay element (VZS) is connected to the output of the integrator (IR).

**6.** Phase locked loop according to Claim 5, **characterized in that** a further delay element (VZ) is connected to the output of the oscillator (VCO) in order to provide a clock output signal (CL*).

**7.** Phase locked loop according to one of Claims 4 to 6, **characterized in that** a matching cascade circuit is provided, which is connected to the digital phase detector (DPD) and to the integrator (IR), and has at least one further control delay element ($T_2$) for matching the phase angle of a data output signal (D0).

**8.** Phase locked loop according to one of Claims 1 to 7, **characterized in that** the integrator (IR) is in the form of a low-pass filter.

**9.** Phase locked loop according to Claim 6, **characterized in that** the delay element ($\tau$) of the further delay element (VZ) is shorter than a lower limit of the adjustable time delay (TD) of the controlled delay element (VZS).

**Revendications**

**1.** Boucle de régulation de phase destinée à récupérer un signal d'horloge (CL) d'un signal de données (DS), laquelle boucle de régulation de phase comporte

- une boucle de régulation de temporisation (DLL) comportant

  * un détecteur de phase (DPD) présentant une première entrée (M) qui est couplée à une borne d'amenée d'un signal (CL1) pouvant être dérivé du signal d'horloge (CL) et une deuxième entrée (P) qui est couplée à une borne d'amenée du signal de données (DS),
  * un intégrateur (IR) qui est raccordé à une sortie du détecteur de phase (DPD) et
  * un élément de temporisation (VZS), dont une entrée de commande (ST) est raccordée à une sortie de l'intégrateur (IR) et qui est reliée en sortie à l'une des deux entrées du détecteur de phase (DPD),

- un filtre de boucle (LF), qui est raccordé à la sortie de l'intégrateur (IR) et
- un oscillateur commandé en tension (VCO), qui est raccordée en entrée à une sortie du filtre de boucle (LF) et duquel peut être dérivé le signal d'horloge (CL),

**caractérisée en ce que**

- la boucle de filtre (LF) comporte une partie formant régulateur proportionnel et intégral, et
- le détecteur de phase (DPD) est un détecteur de phase non linéaire, dont la sortie délivre un signal qui peut prendre un parmi trois états seulement, à savoir

  * un premier état dans lequel la phase du signal d'horloge est en avance sur la phase du signal de données,
  * un deuxième état dans lequel la phase du signal d'horloge est en retard sur la phase du signal de données, et
  * un troisième état dans lequel les positions de phases se superposent ou bien ne sont pas connues instantanément, ou

- le détecteur de phase (DPD) est un détecteur de phase non linéaire, dont la sortie délivre un signal binaire.

**2.** Boucle de régulation de phase selon la revendication 1, **caractérisée en ce que** l'élément de temporisation (VZS) est raccordé entre la borne d'amenée du signal de données (DS) et la deuxième entrée du détecteur de phase (DPD).

**3.** Boucle de régulation de phase selon la revendication 2, **caractérisée en ce que**, pour commander l'élément de temporisation (VZS), celui-ci est raccordé à la sortie de l'intégrateur (IR).

**4.** Boucle de régulation de phase selon la revendication 1, **caractérisée en ce que** l'élément de temporisation (VZS) est raccordé entre la sortie de l'oscillateur commandé en tension (VCO) et la première entrée du détecteur de phase (DPD).

**5.** Boucle de régulation de phase selon la revendication 4, **caractérisée en ce que**, pour commander l'élément de temporisation (VZS), celui-ci est raccordé à la sortie de l'intégrateur (IR).

**6.** Boucle de régulation de phase selon la revendication 5, **caractérisée en ce qu'**un autre élément de temporisation (VZ) est raccordé à la sortie de l'oscillateur (VCO) afin de délivrer un signal d'horloge de sortie (CL*).

7. Boucle de régulation de phase selon l'une des revendications 4 à 6,
   **caractérisée en ce qu'**il est prévu un circuit d'adaptation en cascade, qui est raccordé au détecteur de phase numérique (DPD) et à l'intégrateur (IR) et qui comporte au moins un autre élément de temporisation commandé ($T_2$) pour l'adaptation de la position de phase d'un signal de données de sortie (D0).

8. Boucle de régulation de phase selon l'une des revendications 1 à 7, **caractérisée en ce que** l'intégrateur (IR) est conformé en filtre passe-bas.

9. Boucle de régulation de phase selon la revendication 6, **caractérisée en ce que** le temps de retard ($\tau$) de l'autre élément de temporisation (VZ) est inférieur à une limite inférieure du temps de retard réglable (TD) de l'élément de temporisation commandé (VZS).

# FIG 1

# FIG 2

## FIG 3

## FIG 4